# EUROPÄISCHE PATENTANMELDUNG

(11) **EP 4 163 537 A1**
(43) Veröffentlichungstag der Anmeldung: **12.04.2023**
(21) Anmeldenummer: 21201808.9
(22) Anmeldetag: 11.10.2021
(51) Int. Cl.: F21S 45/47, F21V 17/10, F21V 29/508, F21V 29/70

(54) **LEITERPLATTENANORDNUNG FÜR EINEN KRAFTFAHRZEUGSCHEINWERFER**

(71) Anmelder: ZKW Group GmbH, 3250 Wieselburg (AT)
(72) Erfinder: Kieslinger, Dietmar, 2604 Theresienfeld (AT); Schwarz, Sebastian, 2763 Pernitz (AT)
(74) Vertreter: Patentanwaltskanzlei Matschnig & Forsthuber OG

(57) **Zusammenfassung**

Leiterplattenanordnung (10) für einen Kraftfahrzeugscheinwerfer, umfassend eine Leiterplatte (50) und einen Kühlkörper (60), welche zumindest bereichsweise derart mit einem Abstand (X) zueinander beabstandet sind, sodass zwischen der Leiterplatte (50) und dem Kühlkörper (60) ein Spaltraum (70) gebildet ist, wobei die Leiterplatte (50) an dem Kühlkörper (60) mit zumindest einer Befestigungseinrichtung (80) unter Beibehaltung des Spaltraumes (70) befestigt ist, wobei die zumindest eine Befestigungseinrichtung (80) Folgendes umfasst:
- eine Befestigungsöffnung (100), welche Befestigungsöffnung (100) die Leiterplatte (50) vollständig durchsetzt,
- eine Ausnehmung (200), welche an dem Kühlkörper (70) angeordnet ist, und welche eine Einführöffnung (210) aufweist, und
- ein Befestigungselement (300) mit einer Längsachse (A), wobei
das Befestigungselement (300) durch Ausübung einer Kraft (F) an einem Eingriffsabschnitt (310) und einer dazu entgegen gerichteten Gegenkraft an einem Anlageabschnitt (320) derart umgeformt ist, dass das Befestigungselement (300) in der Ausnehmung (200) formschlüssig verklemmt ist und ein erster und einer zweiter Verbreiterungsabschnitt (330a, 330b) des Befestigungselements (300) ausgebildet ist, wobei sich der erste Verbreiterungsabschnitt (330a) in den Spaltraum (70) und über eine Öffnungsgröße der Befestigungsöffnung (100) hinaus erstreckt, sodass der erste Verbreiterungsabschnitt (330a) die Leiterplatte (50) abstützt, wobei sich der zweite Verbreiterungsabschnitt (330b) radial zur Längsachse (A) über die Öffnungsgröße hinaus erstreckt.

## Beschreibung

Die Erfindung betrifft eine Leiterplattenanordnung für einen Kraftfahrzeugscheinwerfer, umfassend eine Leiterplatte und einen Kühlkörper, welcher mit der Leiterplatte in thermischem Kontakt ist und dazu eingerichtet ist, Wärme der Leiterplatte abzuführen, wobei die Leiterplatte und der Kühlkörper zumindest bereichsweise derart mit einem Abstand zueinander beabstandet sind, sodass zwischen der Leiterplatte und dem Kühlkörper ein Spaltraum gebildet ist, wobei die Leiterplatte an dem Kühlkörper mit zumindest einer Befestigungseinrichtung unter Beibehaltung des Spaltraumes befestigt ist, welche Befestigungseinrichtung zumindest Folgendes umfasst:
- eine Befestigungsöffnung mit einer Öffnungsgröße, welche Befestigungsöffnung die Leiterplatte vollständig durchsetzt,
- eine Ausnehmung, welche an dem Kühlkörper angeordnet ist, und welche eine Einführöffnung aufweist, und
- ein Befestigungselement mit einer Längsachse, wobei das Befestigungselement einen Eingriffsabschnitt und einen entlang der Längsachse gegenüberliegenden Anlageabschnitt aufweist,

Die Erfindung betrifft weiters einen Kraftfahrzeugscheinwerfer, umfassend zumindest eine erfindungsgemäße Leiterplattenanordnung.

Um eine Leiterplatte und einen zugehörigen Kühlkörper thermisch miteinander zu verbinden, wird die Leiterplatte an dem Kühlkörper mechanisch angelegt, wobei es unter anderem durch Fertigungsfehler dazu kommen kann, dass die Leiterplatte nicht plan in jedem Bereich an dem Kühlkörper zur Anlage gelangt und bereichsweise ein Spalt bzw. Spaltraum zwischen der Leiterplatte und dem Kühlkörper vorhanden ist.

Gängige Befestigungsmethoden aus dem Stand der Technik zur Befestigung von Leiterplatten an Kühlkörpern sind unter anderem Schrauben oder Nieten.

Allerdings kann die Verwendung solcher Befestigungsmittel dazu führen, dass die Leiterplatte im Bereich der Befestigung durch ständigen Anpressdruck der Schrauben oder Nieten verbogen wird und dadurch Bauteile sowie deren elektrische Verbindungen zur Leiterplatte entweder brechen oder die auf der Leiterplatte angeordneten Leiterbahnen und Bauteile gestört bzw. zerstört werden.

Durch diese Deformation, welche besonders stark in der Nähe der Befestigungspunkte auftritt, können elektronische Bauteile nur in einer größeren Distanz zu den Befestigungspunkten assembliert werden. Somit würde eine Befestigungsvorrichtung, welche den Anpressdruck und dadurch auch die Deformation der Leiterplatte reduziert, ermöglichen, dass die Distanz zwischen elektronischem Bauteil und Befestigungspunkt verringert und somit die Gesamtgröße der Leiterplatte minimiert werden kann.

Es ist eine Aufgabe der Erfindung eine verbesserte Leiterplattenanordnung bereitzustellen.

Diese Aufgabe wird dadurch gelöst, dass die Befestigungsöffnung und die Einführöffnung derart überlappend angeordnet sind, dass das Befestigungselement durch die Befestigungsöffnung und die Einführöffnung aufgenommen ist, wobei das Befestigungselement die Leiterplatte über die Befestigungsöffnung durchsetzt,
und wobei das Befestigungselement durch Ausübung einer Kraft an dem Eingriffsabschnitt und einer dazu entgegen gerichteten Gegenkraft an dem Anlageabschnitt derart umgeformt ist, dass das Befestigungselement in der Ausnehmung formschlüssig verklemmt ist und ein erster und einer zweiter Verbreiterungsabschnitt des Befestigungselements ausgebildet ist,
wobei sich der erste Verbreiterungsabschnitt in den Spaltraum zwischen der Leiterplatte und dem Kühlkörper radial zur Längsachse des Befestigungselements erstreckt, wobei sich der erste Verbreiterungsabschnitt über die Öffnungsgröße der Befestigungsöffnung hinaus derart in den Spaltraum erstreckt, sodass der erste Verbreiterungsabschnitt die Leiterplatte abstützt, um den Abstand zwischen der Leiterplatte und dem Kühlkörper im Bereich der Befestigungsöffnung beizubehalten,
und wobei sich der zweite Verbreiterungsabschnitt radial zur Längsachse des Befestigungselements erstreckt, wobei sich der zweite Verbreiterungsabschnitt über die Öffnungsgröße der Befestigungsöffnung hinaus erstreckt, um den Abstand zwischen der Leiterplatte und dem Kühlkörper im Bereich der Befestigungsöffnung beizubehalten,
und wobei die Leiterplatte im Bereich der Befestigungsöffnung zwischen dem ersten und dem zweiten Verbreiterungsabschnitt des Befestigungselements formschlüssig verklemmt ist.

Es kann vorgesehen sein, dass das Befestigungselement stiftförmig ausgebildet ist.

Es kann vorgesehen sein, dass das Befestigungselement aus Kunststoff oder aus einem Metall hergestellt ist, vorzugsweise aus Aluminium oder einer Aluminiumlegierung hergestellt ist.

Generell sei angemerkt, dass das Material des Befestigungselements derart gewählt sein sollte, dass der E-Modul des Befestigungselements kleiner ist als jener des Kühlkörpers. Zusätzlich sollte beachtet werden, dass die Ausdehnungskoeffizienten der unterschiedlichen Materialien so gewählt sind, dass im Anwendungstemperaturbereich auch bei starken Temperaturschwankungen kein Auflösen der Verbindung möglich ist. Des Weiteren sollte bei der Auswahl des Materials des Befestigungselements die im Automobilbereich auftretenden Umwelteinflüsse, wie großer Temperaturschwankungen und Vibrationen, berücksichtigt werden.

Es kann vorgesehen sein, dass in dem Spaltraum ein wärmeleitendes Material angeordnet ist, um eine bessere thermische Anbindung zwischen der Leiterplatte und dem Kühlkörper zu ermöglichen.

Es kann vorgesehen sein, dass die Ausnehmung zumindest einen Hinterschnitt umfasst, sodass das Befestigungselement durch die formschlüssige Verbindung zwischen dem Befestigungselement und der Ausnehmung gegen eine Bewegung entlang der Längsachse gesichert ist.

Es kann vorgesehen sein, dass die Ausnehmung als Sackloch an dem Kühlkörper ausgebildet ist, wobei das Sackloch einen Widerlagerabschnitt aufweist, an welchem

Widerlagerabschnitt der Anlageabschnitt des Befestigungselements anliegt und zur Ausübung der Gegenkraft vorgesehen ist.

Es kann vorgesehen sein, dass die Ausnehmung als eine den Kühlkörper vollständig durchsetzende Ausnehmung ausgebildet ist.

Es kann vorgesehen sein, dass die Leiterplattenanordnung ein Widerlagerlement umfasst, an welchem der Anlageabschnitt des Befestigungselements anliegt und zur Ausübung der Gegenkraft vorgesehen ist, wobei das Widerlagerelement durch ein von dem Kühlkörper separates Bauteil gebildet ist. Es kann auch vorgesehen sein, dass nach der Kraftausübung auf das Befestigungselement und nach der Entstehung des daraus resultierenden Formschlusses, besagtes Widerlagerelement bei Bedarf wieder vom Kühlkörper entfernbar ist.

Es kann vorgesehen sein, dass das Befestigungselement in einem Querschnitt parallel zur Längsachse trapezförmig ausgebildet ist, wobei vorzugsweise zwei Schenkelelemente in einem Abstand quer zur Längsachse zueinander an der Basis des Trapezes angeordnet sind.

Es kann vorgesehen sein, dass das Befestigungselement durch Fließpressen umgeformt ist. Unter dem Begriff "Fließpressen" ist zu verstehen, dass aus einer Kraft, welche auf ein Material wirkt, im Material eine Druckbeanspruchung entsteht, die, wenn sie die Druckfließgrenze des Werkstoffes überschreitet, zum Fließen des Werkstoffes führt. Wirkt keine Kraft mehr auf das Bauteil ein, bleibt nach der elastischen Rückfederung eine plastische Verformung des Bauteils zurück.

Es kann vorgesehen sein, dass im Spaltraum zwischen dem Kühlkörper und der Leiterplatte zumindest ein Abstandshalter angeordnet ist, um die Beibehaltung des Spaltraumes zu gewährleisten, vorzugsweise um die Beibehaltung einer minimalen Spalthöhe zwischen dem Kühlkörper und der Leiterplatte zu gewährleisten.

Weiters wird die Aufgabe ebenso gelöst durch einen Kraftfahrzeugscheinwerfer, umfassend zumindest eine erfindungsgemäße Leiterplattenanordnung.

Nachfolgend wird die Erfindung anhand von beispielhaften Zeichnungen näher erläutert. Hierbei zeigt
Fig. 1 eine beispielhafte Leiterplattenanordnung in einer Ansicht von oben, wobei die Leiterplattenanordnung einen Kühlkörper und eine darauf mittels Befestigungseinrichtungen befestigte Leiterplatte umfasst,
Fig. 2A eine beispielhafte Befestigungseinrichtung in einem Querschnitt der Leiterplattenanordnung, wobei die Befestigungseinrichtung eine Befestigungsöffnung in der Leiterplatte, eine Ausnehmung in dem Kühlkörper und ein Befestigungselement umfasst, welches Befestigungselement mittels Ausübung einer Kraft und Gegenkraft verformt ist,
Fig. 2B die beispielhafte Befestigungseinrichtung aus Fig. 2A bevor die Kraft und die Gegenkraft auf das Befestigungselement ausgeübt worden ist,
Fig. 3A die beispielhafte Befestigungseinrichtung aus Fig. 3B nachdem die Kraft und Gegenkraft auf das Befestigungselement ausgeübt worden ist,
Fig. 3B eine weitere beispielhafte Befestigungseinrichtung in einem Zustand bevor Kraft auf das Befestigungselement ausgeübt worden ist,
Fig. 4A ein weiteres Beispiel einer Befestigungseinrichtung vor Kraftausübung zum Verformen des Befestigungselements,
Fig. 4B das Beispiel aus Fig. 4A nach der Verformung des Befestigungselements,
Fig. 5 ein weiteres Beispiel einer Befestigungseinrichtung, wobei die Befestigungseinrichtung weiters Abstandshalter umfasst, und
Fig. 6 mehrere Beispiele für mögliche Befestigungselemente.

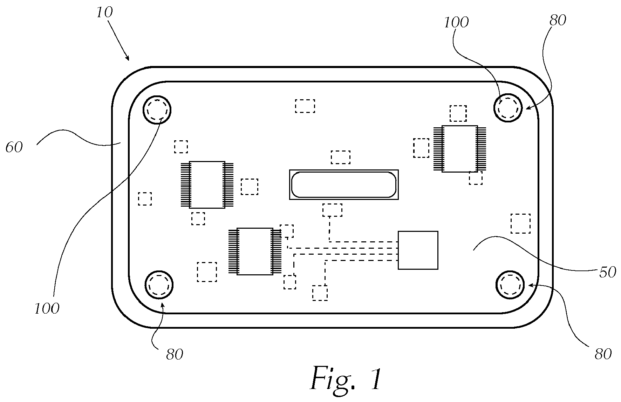

**Fig. 1** zeigt eine beispielhafte Leiterplattenanordnung **10** für einen Kraftfahrzeugscheinwerfer, umfassend eine Leiterplatte **50** und einen Kühlkörper **60** in einer Ansicht von oben, wobei sich der Kühlkörper mit der Leiterplatte **50** in thermischem Kontakt befindet und dazu eingerichtet ist, die durch den Betrieb der Leiterplatte **50** entstehende Wärme der Leiterplatte **50** abzuführen.

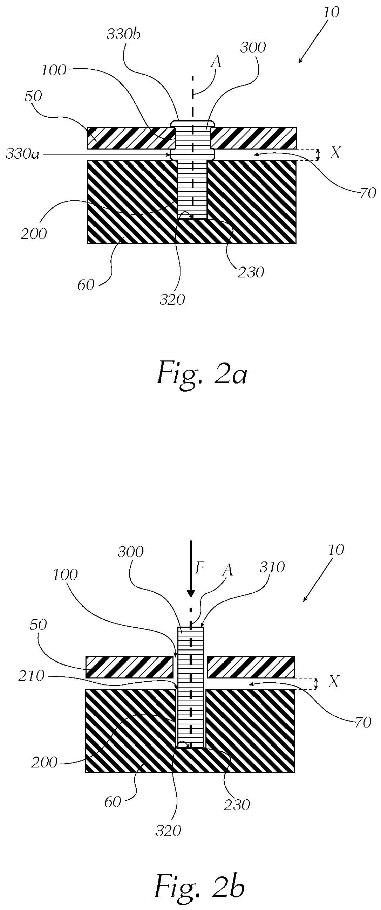

Wie in **Fig. 2a** bzw. **Fig. 2b** ersichtlich, sind die Leiterplatte **50** und der Kühlkörper **60** zumindest bereichsweise derart mit einem Abstand X zueinander beabstandet, sodass zwischen der Leiterplatte **50** und dem Kühlkörper **60** ein Spaltraum **70** gebildet ist, wobei die Leiterplatte **50** an dem Kühlkörper **60** mit mehreren Befestigungseinrichtungen **80** unter Beibehaltung des Spaltraumes **70** befestigt ist. Beispiele für mögliche Ausführungen von Befestigungseinrichtungen **80** sind in den nachfolgenden Figuren gezeigt.

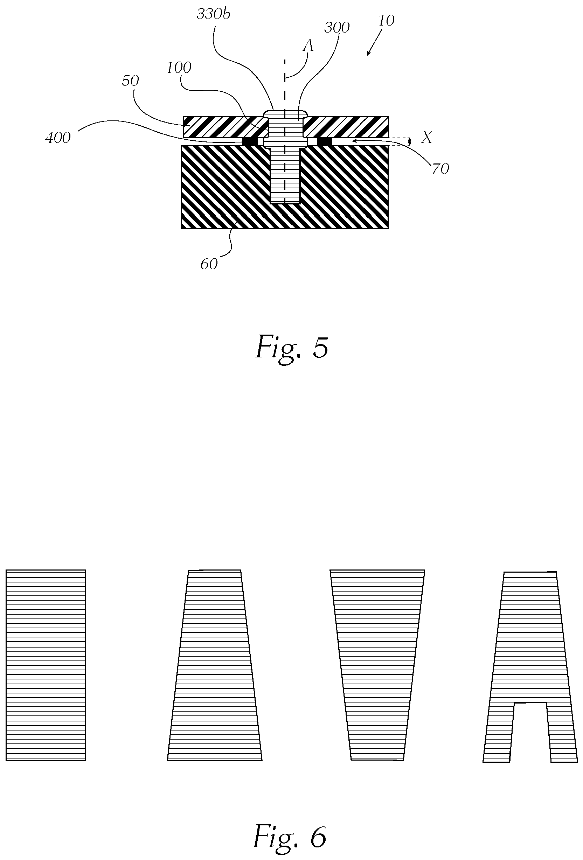

Die Befestigungseinrichtungen **80** umfassen jeweils eine Befestigungsöffnung **100** mit einer Öffnungsgröße, welche Befestigungsöffnung **100** die Leiterplatte **50** vollständig durchsetzt, eine Ausnehmung **200,** welche an dem Kühlkörper **60** angeordnet ist und eine Einführöffnung **210** aufweist, ein Befestigungselement **300** mit einer Längsachse **A,** wobei das Befestigungselement **300** einen Eingriffsabschnitt **310** und einen entlang der Längsachse A gegenüberliegenden Anlageabschnitt **320** aufweist, wie beispielhaft in **Fig. 2**A zu sehen ist. In dem gezeigten Beispiel ist das Befestigungselement **300** stiftförmig ausgebildet, wobei auch andere Formen denkbar sind, wie beispielsweise ein in einem Querschnitt parallel zur Längsachse A trapezförmiges Befestigungselement. Andere Formen sind ebenso in **Fig. 6** dargestellt.

Das Befestigungselement **300** ist in den gezeigten Beispielen aus Aluminium oder einer Aluminiumlegierung hergestellt.

Dabei sind die Befestigungsöffnung **100** und die Einführöffnung **210** derart überlappend angeordnet, dass das Befestigungselement **300** durch die Befestigungsöffnung **100** und die Einführöffnung **210** aufgenommen ist, wobei das Befestigungselement **300** die Leiterplatte **50** über die Befestigungsöffnung **100** durchsetzt.

Das Befestigungselement **300** ist durch Ausübung einer Kraft F an dem Eingriffsabschnitt **310** und einer dazu entgegen gerichteten Gegenkraft an dem Anlageabschnitt **320** derart umgeformt, dass das Befestigungselement **300** in der Ausnehmung **200** formschlüssig verklemmt ist und ein erster und ein zweiter Verbreiterungsabschnitt **330a, 330b** des Befestigungselements **300** ausgebildet ist. Die Umformung ist in den gezeigten Beispielen mittels Fließpressen erfolgt.

In dem gezeigten Beispiel in **Fig. 2A** ist die Ausnehmung **200** als Sackloch an dem Kühlkörper **60** ausgebildet, wobei das Sackloch einen Widerlagerabschnitt **230** aufweist, an welchem Widerlagerabschnitt **230** der Anlageabschnitt **320** des Befestigungselements **300** anliegt und zur Ausübung der Gegenkraft vorgesehen ist.

Der erste Verbreiterungsabschnitt **330a** erstreckt sich in den Spaltraum **70** zwischen der Leiterplatte **50** und dem Kühlkörper **60** radial zur Längsachse **A** des Befestigungselements **300,** wobei sich der erste Verbreiterungsabschnitt **330a** über die Öffnungsgröße der Befestigungsöffnung **100** hinaus derart in den Spaltraum **70** erstreckt, sodass der erste Verbreiterungsabschnitt **330a** die Leiterplatte **50** abstützt, um den Abstand **X** zwischen der Leiterplatte **50** und dem Kühlkörper **60** im Bereich der Befestigungsöffnung **100** beizubehalten.

Der zweite Verbreiterungsabschnitt **330b** erstreckt sich radial zur Längsachse A des Befestigungselements **300,** wobei sich der zweite Verbreiterungsabschnitt **330b** über die Öffnungsgröße der Befestigungsöffnung **100** hinaus erstreckt, um den Abstand **X** zwischen der Leiterplatte **50** und dem Kühlkörper **60** im Bereich der Befestigungsöffnung **100** beizubehalten, und um die Leiterplatte **50** gegen eine Bewegung in Richtung entgegen der Ausnehmung **200** zu sichern.

Dabei ist die Leiterplatte **50** zwischen dem ersten und dem zweiten Verbreiterungsabschnitt **330a, 330b** des Befestigungselements **300** formschlüssig verklemmt.

**Fig. 2B** zeigt die Befestigungseinrichtung **80** aus **Fig. 2A** in einem Zustand bevor das Befestigungselement **300** mittels Fließpressen umgeformt bzw. deformiert ist.

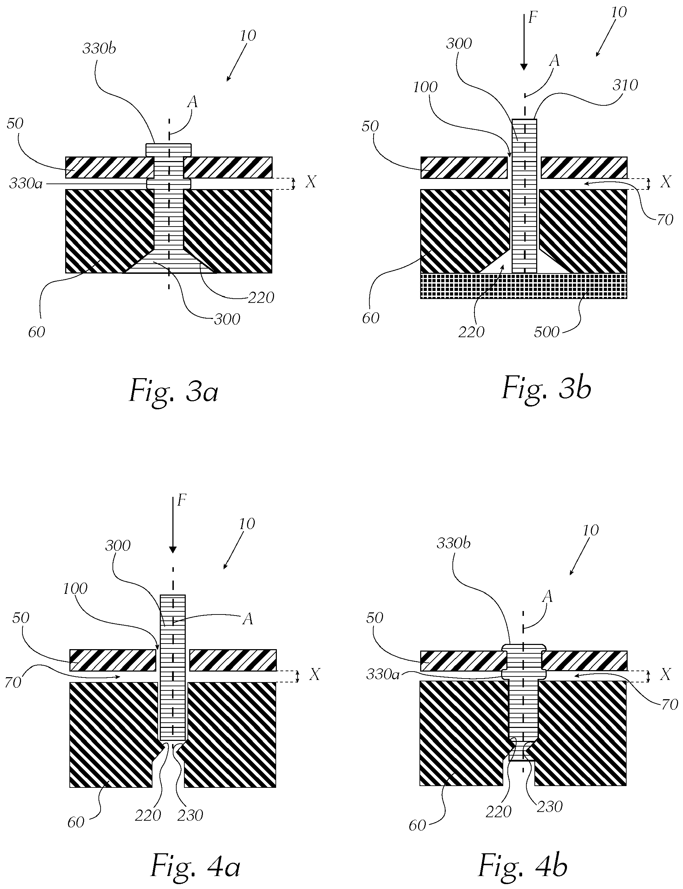

**Fig. 3A** zeigt ein weiteres Beispiel einer Befestigungseinrichtung **80,** wobei das zuvor Gesagte ebenfalls zutrifft. Der Unterschied zum vorherigen Beispiel liegt darin, dass die Ausnehmung **200** als eine den Kühlkörper **60** vollständig durchsetzende Ausnehmung **200** ausgebildet ist, sowie dass die Ausnehmung **200** einen Hinterschnitt **220** umfasst, sodass das Befestigungselement **300** durch die formschlüssige Verbindung zwischen dem Befestigungselement **300** und der Ausnehmung **200** gegen eine Bewegung entlang der Längsachse **A** zusätzlich zum Verklemmen gesichert ist.

**Fig. 3B** zeigt die Befestigungseinrichtung **80** aus **Fig. 3A** in einem Zustand bevor das Befestigungselement **300** mittels Fließpressen umgeformt bzw. deformiert ist, wobei zur Erzeugung der Gegenkraft ein temporär angeordneter Gegenhalter bzw. Widerlagerelement **500** vorgesehen ist.

**Fig. 4A** und **Fig. 4B** zeigen ein weiteres Beispiel einer Befestigungseinrichtung **80,** wobei zur Erzeugung der Gegenkraft die Ausnehmung **200** einen Widerlagerabschnitt **230** umfasst, welcher gleichzeitig als Hinterschnitt im Sinne des vorherigen Beispiels fungiert.

**Fig. 5** zeigt ein weiteres Beispiel einer beispielhaften Befestigungseinrichtung **80,** wobei das zuvor Gesagte ebenfalls auf dieses Beispiel zutrifft. Der Unterschied zu den vorherigen Beispielen, insbesondere aus dem Beispiel gezeigt in **Fig. 2A** bzw. **Fig. 2B** liegt darin, dass die Befestigungseinrichtung **80** Abstandshalter **400** umfasst, welche im Spaltraum **70** zwischen dem Kühlkörper **60** und der Leiterplatte **50** angeordnet sind, um die Beibehaltung des Spaltraumes **70** zusätzlich zu verbessern bzw. zu gewährleisten.

**Fig. 6** zeigt mögliche Ausführungsformen des Befestigungselements **300,** wobei sich der Schutzumfang nicht ausschließlich auf diese hier dargestellten geometrischen Formen bezieht. Eine besonders günstige Form für das Befestigungselement stellt die erste Form von rechts in Fig. 6 dar. Hierbei ist das Befestigungselement in einem Querschnitt parallel zur Längsachse trapezförmig ausgebildet, wobei zwei Schenkelelemente in einem Abstand quer zur Längsachse zueinander an der Basis des Trapezes angeordnet sind.

### LISTE DER BEZUGSZEICHEN

- Leiterplattenanordnung: 10
- Leiterplatte: 50
- Kühlkörper: 60
- Spaltraum: 70
- Befestigungseinrichtungen: 80
- Befestigungsöffnung: 100
- Ausnehmung: 200
- Einführöffnung: 210
- Hinterschnitt: 220
- Widerlagerabschnitt: 230
- Befestigungselement: 300
- Eingriffsabschnitt: 310
- Anlageabschnitt: 320
- Erster Verbreiterungsabschnitt: 330a
- Zweiter Verbreiterungsabschnitt: 330b
- Abstandhalter: 400
- Gegenhalter: 500
- Längsachse: A
- Abstand: X

## Patentansprüche

1. Leiterplattenanordnung (10) für einen Kraftfahrzeugscheinwerfer, umfassend eine Leiterplatte (50) und einen Kühlkörper (60), welcher mit der Leiterplatte (50) in thermischem Kontakt ist und dazu eingerichtet ist, Wärme der Leiterplatte (50) abzuführen, wobei die Leiterplatte (50) und der Kühlkörper (60) zumindest bereichsweise derart mit einem Abstand (X) zueinander beabstandet sind, sodass zwischen der Leiterplatte (50) und dem Kühlkörper (60) ein Spaltraum (70) gebildet ist, wobei die Leiterplatte (50) an dem Kühlkörper (60) mit zumindest einer Befestigungseinrichtung (80) unter Beibehaltung des Spaltraumes (70) befestigt ist, welche zumindest eine Befestigungseinrichtung (80) Folgendes umfasst:
- eine Befestigungsöffnung (100) mit einer Öffnungsgröße, welche Befestigungsöffnung (100) die Leiterplatte (50) vollständig durchsetzt,
- eine Ausnehmung (200), welche an dem Kühlkörper (70) angeordnet ist, und welche eine Einführöffnung (210) aufweist, und
- ein Befestigungselement (300) mit einer Längsachse (A), wobei das Befestigungselement (300) einen Eingriffsabschnitt (310) und einen entlang der Längsachse (A) gegenüberliegenden Anlageabschnitt (320) aufweist,
**dadurch gekennzeichnet, dass**
die Befestigungsöffnung (100) und die Einführöffnung (210) derart überlappend angeordnet sind, dass das Befestigungselement (300) durch die Befestigungsöffnung (100) und die Einführöffnung (210) aufgenommen ist, wobei das Befestigungselement (300) die Leiterplatte (50) über die Befestigungsöffnung (100) durchsetzt,
und wobei das Befestigungselement (300) durch Ausübung einer Kraft (F) an dem Eingriffsabschnitt (310) und einer dazu entgegen gerichteten Gegenkraft an dem Anlageabschnitt (320) derart umgeformt ist, dass das Befestigungselement (300) in der Ausnehmung (200) formschlüssig verklemmt ist und ein erster und ein zweiter Verbreiterungsabschnitt (330a, 330b) des Befestigungselements (300) ausgebildet ist,
wobei sich der erste Verbreiterungsabschnitt (330a) in den Spaltraum (70) zwischen der Leiterplatte (50) und dem Kühlkörper (60) radial zur Längsachse (A) des Befestigungselements (300) erstreckt, wobei sich der erste Verbreiterungsabschnitt (330a) über die Öffnungsgröße der Befestigungsöffnung (100) hinaus derart in den Spaltraum (70) erstreckt, sodass der erste Verbreiterungsabschnitt (330a) die Leiterplatte (50) abstützt, um den Abstand (X) zwischen der Leiterplatte (50) und dem Kühlkörper (60) im Bereich der Befestigungsöffnung (100) beizubehalten,
und wobei sich der zweite Verbreiterungsabschnitt (330b) radial zur Längsachse (A) des Befestigungselements (300) erstreckt, wobei sich der zweite Verbreiterungsabschnitt (330b) über die Öffnungsgröße der Befestigungsöffnung (100) hinaus erstreckt, um den Abstand (X) zwischen der Leiterplatte (50) und dem Kühlkörper (60) im Bereich der Befestigungsöffnung (100) beizubehalten, und um die Leiterplatte (50) gegen eine Bewegung in Richtung entgegen der Ausnehmung (200) zu sichern,
und wobei die Leiterplatte (50) zwischen dem ersten und dem zweiten Verbreiterungsabschnitt (330a, 330b) des Befestigungselements (300) formschlüssig verklemmt ist.

2. Leiterplattenanordnung nach Anspruch 1, **dadurch gekennzeichnet, dass** das Befestigungselement (300) stiftförmig ausgebildet ist.

3. Leiterplattenanordnung nach Anspruch 1 oder 2, **dadurch gekennzeichnet, dass** das Befestigungselement (300) aus Kunststoff oder aus einem Metall hergestellt ist, vorzugsweise aus Aluminium oder einer Aluminiumlegierung hergestellt ist.

4. Leiterplattenanordnung nach einem der Ansprüche 1 bis 3, **dadurch gekennzeichnet, dass** die Ausnehmung (200) zumindest einen Hinterschnitt (220) umfasst, sodass das Befestigungselement (300) durch die formschlüssige Verbindung zwischen dem Befestigungselement (300) und der Ausnehmung (200) gegen eine Bewegung entlang der Längsachse (A) gesichert ist.

5. Leiterplattenanordnung nach einem der Ansprüche 1 bis 4, **dadurch gekennzeichnet, dass** die Ausnehmung (200) als Sackloch an dem Kühlkörper (60) ausgebildet ist, wobei das Sackloch einen Widerlagerabschnitt (230) aufweist, an welchem Widerlagerabschnitt (230) der Anlageabschnitt (320) des Befestigungselements (300) anliegt und zur Ausübung der Gegenkraft vorgesehen ist.

6. Leiterplattenanordnung nach einem der Ansprüche 1 bis 4, **dadurch gekennzeichnet, dass** die Ausnehmung (200) als eine den Kühlkörper (60) vollständig durchsetzende Ausnehmung (200) ausgebildet ist.

7. Leiterplattenanordnung nach einem der Ansprüche 1 bis 6, **dadurch gekennzeichnet, dass** das Befestigungselement (300) in einem Querschnitt parallel zur Längsachse (A) trapezförmig ausgebildet ist, wobei vorzugsweise zwei Schenkelelemente in einem Abstand quer zur Längsachse (A) zueinander an der Basis des Trapezes angeordnet sind.

8. Leiterplattenanordnung nach einem der Ansprüche 1 bis 7, **dadurch gekennzeichnet, dass** das Befestigungselement (300) durch Fließpressen umgeformt ist.

9. Leiterplattenanordnung nach einem der Ansprüche 1 bis 8, **dadurch gekennzeichnet, dass** im Spaltraum (70) zwischen dem Kühlkörper (60) und der Leiterplatte (50) zumindest ein Abstandshalter (400) angeordnet ist, um die Beibehaltung des Spaltraumes (70) zu gewährleisten.

10. Leiterplattenanordnung nach einem der Ansprüche 1 bis 9, **dadurch gekennzeichnet, dass** die Leiterplattenanordnung (10) ein Widerlagerelement (500) umfasst, an welchem der Anlageabschnitt (320) des Befestigungselements (300) anliegt und zur Ausübung der Gegenkraft vorgesehen ist, wobei das Widerlagerelement (500) durch ein von dem Kühlkörper separates Bauteil gebildet ist, wobei das Widerlagerelement (500) nach der Kraftausübung auf das Befestigungselement (300) und nach der Entstehung des daraus resultierenden Formschlusses vom Kühlkörper entfernbar ist.

11. Kraftfahrzeugscheinwerfer, umfassend zumindest eine Leiterplattenanordnung (10) nach einem der Ansprüche 1 bis 10.
